(19) **Europäisches Patentamt / European Patent Office / Office européen des brevets**

(11) **EP 1 936 789 B1**

(12) **EUROPÄISCHE PATENTSCHRIFT**

(45) Veröffentlichungstag und Bekanntmachung des Hinweises auf die Patenterteilung:
**02.05.2012 Patentblatt 2012/18**

(51) Int Cl.:
*H02M 1/08* (2006.01)   *H02M 7/538* (2007.01)
*H02M 1/38* (2007.01)   *H03K 17/28* (2006.01)
*H03K 5/151* (2006.01)   *H03K 17/26* (2006.01)

(21) Anmeldenummer: **07018348.8**

(22) Anmeldetag: **19.09.2007**

(54) **Umrichter mit einer Verzögerungsschaltung für PWM-Signale**

Converter with a delay circuit for PWM signals

Circuit de delai pour un convertisseur MLI

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **22.12.2006 DE 102006060828**

(43) Veröffentlichungstag der Anmeldung:
**25.06.2008 Patentblatt 2008/26**

(73) Patentinhaber: **Dr. Johannes Heidenhain GmbH 83301 Traunreut (DE)**

(72) Erfinder: **Huber, Norbert 83317 Teisendorf (DE)**

(56) Entgegenhaltungen:
**JP-A- 58 034 620     JP-A- 58 117 725
JP-A- 2005 110 366**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 1 936 789 B1

**Beschreibung**

Die Erfindung betrifft einen Umrichter mit einer Verzögerungsschaltung für PWM-Signale. Solche Umrichter finden breite Anwendung z.B. im Bereich der Antriebstechnik, um elektrische Motoren mit Strom zu versorgen.

Zur Versorgung eines elektrischen Motors mit Strom ist es bekannt, die in einem Zwischenkreis zur Verfügung stehende Gleichspannung mittels einer Halbbrückenschaltung in Wechselstrom für die einzelnen Motorphasen umzuwandeln. Pro Motorphase wird dafür eine Halbbrückenschaltung benötigt, mit deren beiden Halbleiterschaltelementen die Motorphase abwechselnd auf die positive bzw. negative Stromschiene des Zwischenkreises geschaltet wird. Üblicherweise kommt dabei das Pulsweitenmodulationsverfahren (PWM-Verfahren) zum Einsatz, bei dem ein PWM-Signal so aufbereitet wird, dass damit die beiden Halbleiterschaltelemente angesteuert werden können.

Die DE 102005020805 A1 beschreibt eine solche nach dem PWM-Verfahren betriebene Halbbrückenschaltung und erklärt, dass beim Umschalten zwischen den beiden Halbleiterschaltelementen die Einhaltung einer Verriegelungszeit bzw. Blockzeit wichtig ist, während der beide Halbleiterschalt-elemente ausgeschaltet und damit nicht leitend sind, da ansonsten ein Kurzschluss zwischen positiver und negativer Stromschiene droht. Die DE 102005020805 A1 erläutert auch, wie eine solche Blockzeit erzeugt werden kann: Durch das Verzögern von steigenden Flanken der PWM-Signale wird sichergestellt, dass eine Blockzeit eingehalten wird. Gemäß wenigstens einem Ausführungsbeispiel in der genannten Schrift werden auch die fallenden Flanken der PWM-Signale verzögert, und zwar um eine Ausschaltverzögerung (td1), die kleiner ist als die Einschaltverzögerung (te1 + td1) der steigenden Flanken. Die Blockzeit ist dann die Differenz der beiden Verzögerungszeiten.

Die JP 58034620 A zeigt einen Umrichter mit einer Verzögerungsschaltung für ein am Eingang der Verzögerungsschaltung anliegendes PWM-Signal durch die steigende Flanken des PWM-Signals um eine Einschaltverzögerung und fallende Flanken des PWM-Signals um eine Ausschaltverzögerung verzögert werden zum Bilden eines am Ausgang der Verzögerungsschaltung anliegenden Ansteuersignals für ein Halbleiterschaltelement, wobei

- der Eingang über einen ersten Widerstand mit einem ersten Anschluss eines ersten Kondensators verbunden ist, dessen zweiter Anschluss konstant auf einem Low-Pegel (L) liegt.

Aufgabe der vorliegenden Erfindung ist es, einen Umrichter mit einer möglichst einfachen Verzögerungsschaltung anzugeben, mit der eine Einschaltverzögerung für steigende Flanken und eine Ausschaltverzögerung für fallende Flanken eines PWM-Signals bewirkt werden kann.

Diese Aufgabe wird gelöst durch einen Umrichter gemäß Anspruch 1.

Die Verzögerungsschaltung enthält einen ersten Kondensator, dessen Ladezustand den Spannungspegel am Eingang eines Komparators bestimmt. Schaltet ein PWM-Signal am Eingang der Verzögerungsschaltung von einem Low-Pegel auf einen High-Pegel, so wird der erste Kondensator über eine Serienschaltung aus einem ersten und einem zweiten Widerstand geladen. Durch eine zum zweiten Widerstand parallel geschaltete Diode wird dieser zweite Widerstand überbrückt, wenn der erste Kondensator nach einem Wechsel des PWM-Signals von einem High-Pegel auf einen Low-Pegel entladen wird. Das Entladen des Kondensators erfolgt daher schneller als das Laden.

Da der Ladezustand des Kondensators den Spannungspegel am Eingang des Komparators bestimmt, und dieser bei überschreiten eines Einschaltpegels seinen Ausgang von einem Low-Pegel auf einen High-Pegel schaltet, und bei unterschreiten eines Ausschaltpegels seinen Ausgang von einem High-Pegel auf einen Low-Pegel schaltet, lassen sich steigende und fallende Schaltflanken des PWM-Signals unterschiedlich verzögern. Die steigenden Flanken werden mit einer Einschaltverzögerung verzögert, die größer ist als eine Ausschaltverzögerung, mit der die fallenden Flanken des PWM-Signals verzögert werden.

Die Blockzeit, für die zwei Halbleiterschaltelemente einer Halbbrücke gleichzeitig ausgeschaltet sind, entspricht der Differenz aus der Einschaltverzögerung und der Ausschaltverzögerung.

Die beschriebene Verzögerungsschaltung sorgt außerdem dafür, dass die zum Schalten der Halbleiterschalter verwendeten Signale eine Mindestpulsdauer entsprechend der Ausschaltverzögerung nicht unterschreiten. Negative Effekte von zu kurzen Einschaltdauern der Halbleiterschaltelemente können so vermieden werden. Solche zu kurze Einschaltdauern können nämlich dazu führen, dass in Freilaufdioden, die den Halbleiterschaltelementen parallel geschaltet sind, ein Stromabreißverhalten auftritt, wodurch sich der Strom sehr schnell ändert und über vorhandene Streuinduktivitäten hohe Spannungen induziert werden, die die beteiligten Leistungshalbleiter zerstören können.

Weitere Vorteile sowie Einzelheiten der vorliegenden Erfindung ergeben sich aus der nachfolgenden Beschreibung einer bevorzugten Ausführungsform anhand der Figuren. Dabei zeigt

Figur 1    eine Halbbrücke in einem Umrichter,

Figur 2    PWM-Signale zur Ansteuerung einer Halbbrücke,

Figur 3    eine Verzögerungsschaltung für PWM-Signale,

Figur 4    Signal- und Potentialdiagramme.

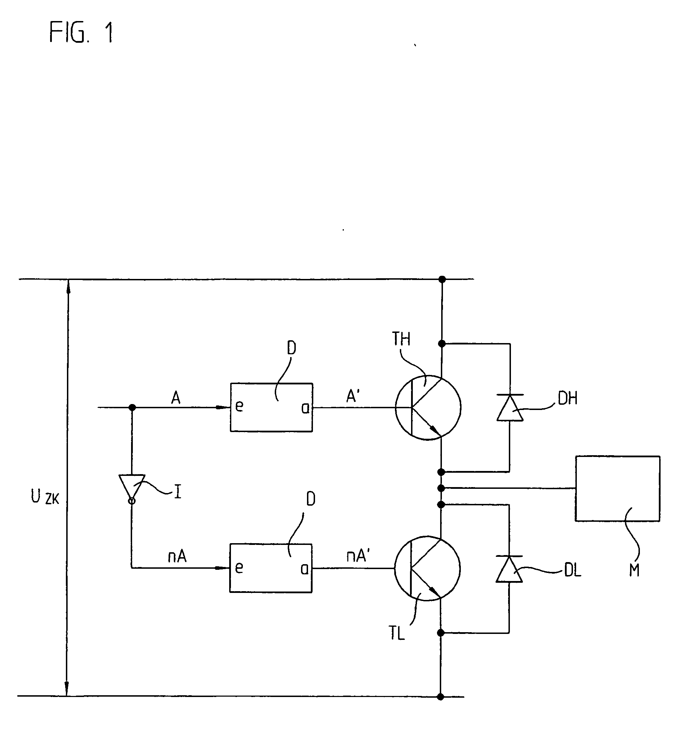

Figur 1 zeigt einen Ausschnitt eines Umrichters. Ein Zwischenkreis stellt eine Gleichspannung Uzk zur Verfügung. Mittels einer Halbbrückenschaltung wird eine Phase eines Motors M (oder allgemeiner: einer Last), abwechselnd auf das positive und negative Potential des Zwischenkreises geschaltet. Die Halbbrückenschaltung besteht dabei aus zwei Halbleiterschaltelementen TH, TL, die abwechselnd leitend bzw. gesperrt sind und niemals beide leitend sein dürfen. Bei diesen Halbleiterschaltelementen TH, TL handelt es sich beispielsweise um IGBTs oder Power-MOSFETs. Parallel zu den Halbleiterschaltelementen TH, TL sind Freilaufdioden DH, DL geschaltet. Durch das Abschalten des Laststromes wird aufgrund der Induktivität der Last eine Spannung induziert, die dem Abschalten entgegenwirkt. Die daraus resultierenden Ströme werden durch die Freilaufdioden DH, DL über den Zwischenkreis weiter geleitet.

Zur Ansteuerung eines üblicherweise dreiphasigen Motors werden drei Halbbrücken, wie sie in der Figur 1 dargestellt sind, benötigt.

Die Ansteuerung einer Halbbrücke, also das Schalten der Halbleiterschaltelemente TH, TL soll im Folgenden erklärt werden. Ein digitales, also zwischen einem High-Pegel und einem Low-Pegel hin- und her springendes PWM-Signal A liegt an der Halbbrücke an. Das Tastverhältnis von A entspricht dabei der Spannung, die an der Phase des Motors M anliegen soll. So liegt die Phase bei einem Tastverhältnis von 0,5 gerade zwischen dem positiven und negativen Potential des Zwischenkreises, also bei 0V. Mit einem Tastverhältnis zwischen 0 und 1 lässt sich also an der Phase des Motors M jede Spannung zwischen dem negativen und positiven Potential des Zwischenkreises einstellen.

Da die beiden Halbleiterschaltelemente TH, TL (bis auf die Einhaltung der Blockzeit) gegensinnig geschaltet werden müssen, wird vom PWM-Signal A mittels eines Inverters I ein zu A inverses PWM-Signal nA erzeugt. Sowohl A als auch nA durchlaufen je eine Verzögerungsschaltung D, die wiederum digitale Signale A' bzw. nA' generieren, und deren Funktionsweise unten näher beschrieben wird. Diese Verzögerungsschaltung D sorgt im Wesentlichen für die Einhaltung der Blockzeit. Die Blockzeit ist der zeitliche Abstand zwischen dem Abschalten des einen Halbleiterschaltelements (TH bzw. TL) und dem Einschalten des anderen Halbleiterschaltelements (TL bzw. TH) und beträgt beispielsweise 2μs.

Die Verzögerungsschaltung D verzögert steigende Flanken von A bzw. nA um eine bestimmte, hier Einschaltverzögerung genannte Zeit. Fallende Flanken werden ebenfalls um eine bestimmte, hier Ausschaltverzögerung genannte Zeit verzögert: Die Ausschaltverzögerung ist dabei etwas kürzer als die Einschaltverzögerung.

Zwischen der Verzögerungsschaltung D und dem jeweiligen Halbleiterschaltelement TH, TL können sich noch weitere Schaltungen befinden, wie z.B. Treiberschaltungen oder auch eine Logik, die die PWM-Signale A', nA' nur dann an die Halbleiterschaltelemente TH, TL gibt, wenn eine Pulsfreigabe vorliegt. Hierzu wird ein logisches Freigabesignal mit dem jeweiligen PWM-Signal A', nA' UND - verknüpft. Liegt keine Freigabe vor, sind beide Halbleiterschaltelemente gesperrt.

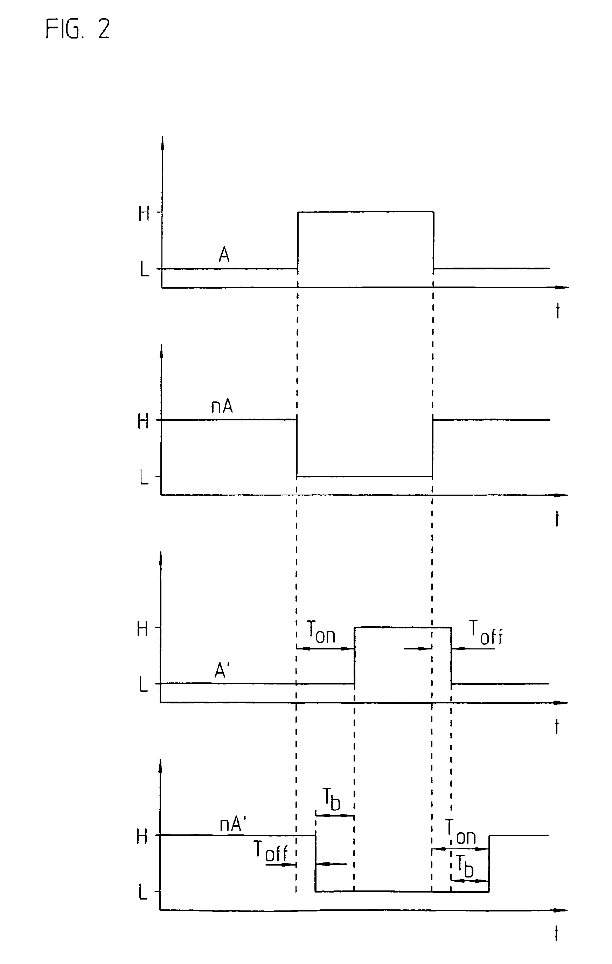

Die Figur 2 zeigt die oben erwähnten PWM-Signale A, nA, A', nA' im zeitlichen Verlauf für einen PWM-Puls im Signal A.

Das Signal nA entspricht dem im Inverter 4 invertierten Signal A.

A' ergibt sich, indem steigende Flanken von A (also ein Wechsel von einem Low-Pegel L auf einen High-Pegel H) um eine Einschaltverzögerung Ton verzögert werden, und fallende Flanken von A (also ein Wechsel von einem High-Pegel H auf einen Low-Pegel L) um eine Ausschaltverzögerung Toff verzögert werden.

Das Signal nA' ergibt sich, indem steigende Flanken von nA um eine Einschaltverzögerung Ton verzögert werden, und fallende Flanken von nA um eine Ausschaltverzögerung Toff verzögert werden. Dies bedeutet, dass nA' keine Invertierung von A' darstellt, sondern das durch die Verzögerungsschaltung D veränderte Signal nA.

Beim Vergleich der Signale A' und nA', die letztlich zur Ansteuerung der Halbleiterschaltelemente TH, TL herangezogen werden, erkennt man, dass jetzt eine Blockzeit von Tb = Ton - Toff eingehalten wird. Typische Werte wären für Ton 2.5μs und für Toff 0,5μs, womit sich wieder die oben erwähnte Blockzeit von 2 μs ergibt.

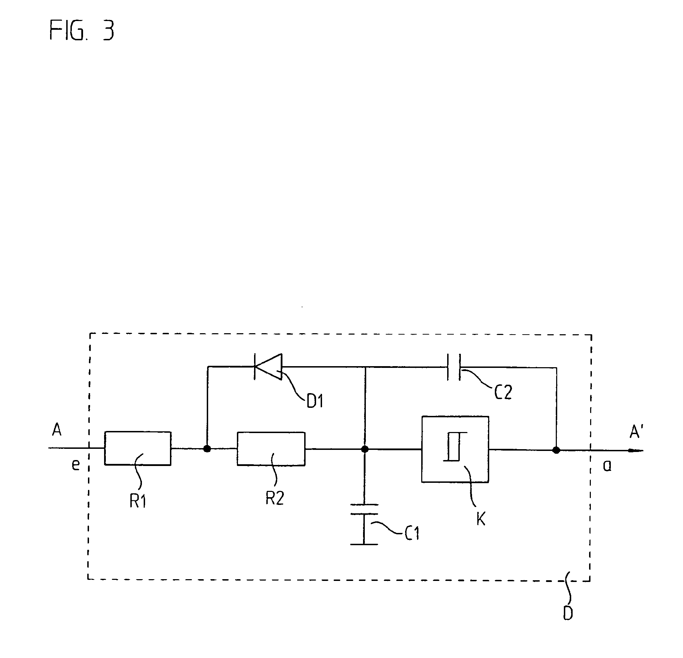

Die Figur 3 zeigt nun die Verzögerungsschaltung D selbst, die pro Halbbrücke zweimal vorhanden ist, da die zum Ansteuern eines jeden Halbleiterschaltelements TH, TL verwendeten Ansteuersignale A' bzw. nA' von je einer solcher Verzögerungsschaltung D stammen. Zum Betreiben eines dreiphasigen Motors M sind also sechs solcher Verzögerungsschaltungen D nötig.

Am Eingang e der Verzögerungsschaltung D liegt das noch unverzögerte PWM-Signal A an. Über eine Serienschaltung aus einem ersten Widerstand R1 und einem zweiten Widerstand R2 gelangt das Signal A zu einem ersten Anschluss eines Kondensators C1, dessen zweiter Anschluss fest auf einem Low-Pegel liegt. Der erste Anschluss des Kondensators C1 ist außerdem mit einem Eingang eines Komparators K verbunden, dessen Ausgang den Ausgang a der Verzögerungsschaltung D bildet. Abhängig vom Spannungspegel am Eingang des Komparators K liegt der Ausgang des Komparators K und damit der Ausgang a der Verzögerungsschaltung D auf einem Low-Pegel oder einem High-Pegel.

Eine Diode D1 ist so parallel zum zweiten Widerstand R2 geschaltet, dass dieser zweite Widerstand R2 zusammen mit dem ersten Widerstand R1 bei einem Wechsel von einem Low-Pegel L zu einem High-Pegel H am Eingang e der Verzögerungsschaltung D einen Ladestrom für den ersten Kondensator C1 begrenzt, während dessen Entladestrom bei einem Wechsel von einem High-Pegel H zu einem Low-Pegel L am Eingang e nur durch den ersten Widerstand R1 begrenzt wird. Dies ist gewährleistet, wenn die Diode D1 bei einem High-Pegel H am Eingang e und einem Low-Pegel am Eingang des Komparators K sperrt, und bei umgekehrten Pegel-Verhältnissen (also bei geladenem Kondensator C1 und einem Low-Pegel L an Eingang e) leitet und den zweiten Widerstand R2 kurzschließt.

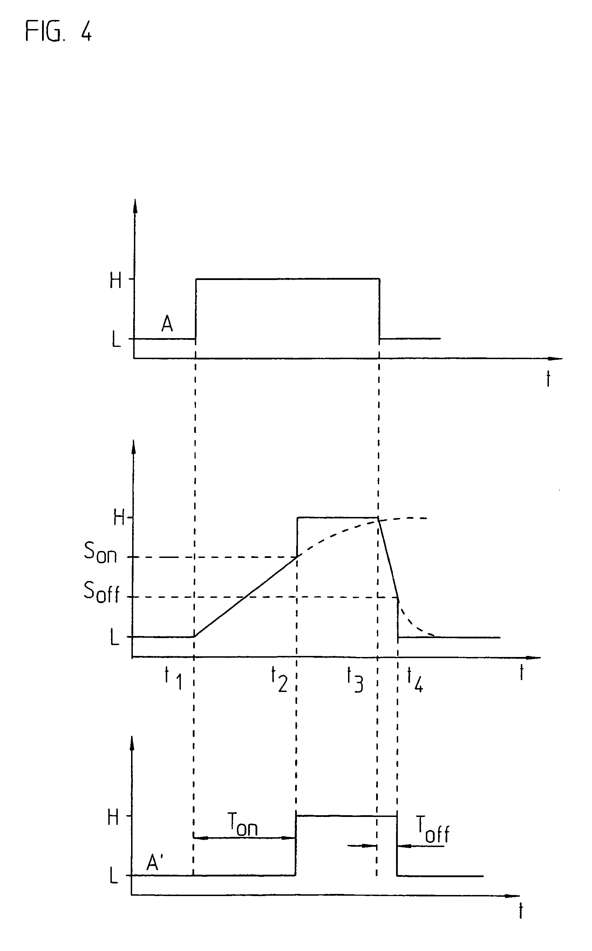

Ein zweiter Kondensator C2 ist parallel zum Komparator K geschaltet, also zwischen dessen Ein- und Ausgang. Die Funktion dieses Kondensators sei anhand der Figur 4 näher erläutert.

Figur 4a zeigt ein Signal A, das am Eingang e der Verzögerungsschaltung D angelegt wird. Es enthält lediglich eine steigende und fallende Flanke.

Figur 4b zeigt den Spannungsverlauf am Eingang des Komparators K, zusammen mit dem Einschaltpegel Son und dem Ausschaltpegel Soff des Komparators K.

Figur 4c zeigt das resultierende Signal A' am Ausgang a der Verzögerungsschaltung D.

Zum Zeitpunkt t1 wechselt Signal A von einem Low-Pegel L auf einen High-Pegel H. Ab diesem Zeitpunkt t1 werden der Kondensator C1 und der Kondensator C2 über den ersten und zweiten Widerstand R1 und R2 geladen, die Spannung am Eingang des Komparators K steigt daher an. Zu einem Zeitpunkt t2 wird der Einschaltpegel Son des Komparators K erreicht, dessen Ausgang in diesem Moment von einem Low-Pegel L auf einen High-Pegel H schaltet. Da der Ausgang des Komparators K gleichzeitig der Ausgang a der Verzögerungsschaltung D ist, schaltet in diesem Moment auch A' auf einen High-Pegel H, gegenüber dem Signal A um eine Einschaltverzögerung Ton (Ton = t2 - t1) später. Die Zeit Ton ist also die Ladezeit des ersten und zweiten Kondensators C1 und C2 bis zum Erreichen des Einschaltpegels Son, und diese Zeit wird bestimmt durch die Reihenschaltung der beiden Widerstände R1 und R2, die den Ladestrom begrenzt.

Ohne den zweiten Kondensator C2 würde der Pegel am Eingang des Komparators K nach dem Zeitpunkt t2 der gestrichelten Linie folgen, und sich dem High-Pegel H annähern. Würde das Signal A nun wieder auf einen Low-Pegel L fallen, bevor am Eingang des Komparators K der volle High-Pegel H an läge, so wäre die Zeit bis zum Erreichen des Abschaltpegels Soff zum Zeitpunkt t3 und damit die Ausschaltverzögerung Toff nicht sauber definiert. Das Entladen des Kondensators C1 würde dann nämlich von einem niedrigeren Pegel aus beginnen.

Da die Ausschaltverzögerung Toff auch den Schaltpuls mit der kürzesten Einschaltdauer des zugeordneten Halbleiterschaltelements TH, TL definiert, könnte eine verkürzte Ausschaltverzögerung zu so kurzen PWM-Pulsen führen, dass wie oben erwähnt die Zerstörung des Halbleiterschaltelements TH, TL droht.

Dieses Problem wird durch den zweiten Kondensator C2 vermieden. Die im Kondensator C2 bis zum Zeitpunkt t2 gespeicherte Ladung steht, da der Kondensator C2 am Ausgang des Komparators auf einen High-Pegel H verschoben wird, zum vollständigen Aufladen des ersten Kondensators C1 zur Verfügung. Deshalb erfolgt wie in Figur 4b dargestellt der Sprung auf den High-Pegel H am Eingang des Komparators K nach t2 praktisch ohne Zeitverzug. Eine auf den Zeitpunkt t2 folgende fallende Flanke im Signal A wird damit immer um die volle Ausschaltverzögerung Toff verzögert, eine minimale Einschaltdauer des zugeordneten Halbleiterschaltelements TH, TL wird somit stets eingehalten.

Zum Zeitpunkt t3 springt das Signal A zurück auf den Low-Pegel L, der Kondensator C1 wird nun über R1 entladen, denn der Widerstand R2 ist beim Entladen durch die Diode D1 überbrückt. Der Entladevorgang ist damit erheblich schneller als der Ladevorgang, die Zeit bis zum Erreichen des Abschaltpegels Soff des Komparators K zum Zeitpunkt t4 und damit die Ausschaltverzögerung Toff (Toff = t4 - t3) ist entsprechend kürzer als die Einschaltverzögerung Ton. Die (kürzere) Ausschaltverzögerung Toff und die (längere) Einschaltverzögerung Ton lassen sich also durch eine geeignete Wahl der Widerstände R1 und R2 sowie der Kondensatoren C1 und C2 festlegen.

Der zweite Kondensator C2 sorgt auch zum Zeitpunkt t4 dafür, dass der Pegel am Eingang des Komparators K praktisch sofort auf den Low-Pegel L fällt, so dass der Komparator K bereit ist für die nächste steigende Flanke von A.

Beispielhaft seien noch Werte zur Dimensionierung der Bauteile der Verzögerungsschaltung D angegeben:

$$R1 = 2k\Omega, R2 = 2.5k\Omega, C1 = 300pF, C2 = 150pF.$$

Für die Verzögerungszeiten gilt näherungsweise:

$$Ton = (R1 + R2) * (C1 + C2)$$

$$Toff = R1 * (C1 + C2)$$

**Patentansprüche**

1. Umrichter mit einer Verzögerungsschaltung für ein am Eingang (e) der Verzögerungsschaltung (D) anliegendes PWM-Signal (A, nA), durch die steigende Flanken des PWM-Signals (A, nA) um eine Einschaltverzögerung (Ton) und fallende Flanken des PWM-Signals (A, nA) um eine Ausschaltverzögerung (Toff) verzögert werden zum Bilden eines am Ausgang (a) der Verzögerungsschaltung (D) anliegenden Ansteuersignals (A', nA') für ein Halbleiterschaltelement (TH, TL), wobei

- der Eingang (e) über eine Serienschaltung aus einem ersten Widerstand (R1) und einem zweiten Widerstand (R2) mit einem ersten Anschluss eines ersten Kondensators (C1) verbunden ist, dessen zweiter Anschluss konstant auf einem Low-Pegel (L) liegt,

- der erste Anschluss des ersten Kondensators (C1) mit einem Eingang eines Komparators (K) verbunden ist, dessen Ausgang den Ausgang (a) der Verzögerungsschaltung (D) bildet, der abhängig von einem Spannungspegel am Eingang des Komparators (K) zwischen einem High-Pegel (H) und einem Low-Pegel (L) wechselt, wobei der Spannungspegel am Eingang des Komparators (K) vom Ladezustand des ersten Kondensators (C1) abhängig ist,

- eine Diode (D1) so parallel zum zweiten Widerstand (R2) geschaltet ist, dass dieser zweite Widerstand (R2) zusammen mit dem ersten Widerstand (R1) bei einem Wechsel von einem Low-Pegel (L) zu einem High-Pegel (H) am Eingang (e) der Verzögerungsschaltung (D) einen Ladestrom für den ersten Kondensator (C1) begrenzt, während dessen Entladestrom bei einem Wechsel von einem High-Pegel (H) zu einem Low-Pegel (L) am Eingang (e) nur durch den ersten Widerstand (R1) begrenzt wird.

2. Umrichter mit einer Verzögerungsschaltung nach Anspruch 1, bei dem die Verzögerungsschaltung (D) außerdem einen zweiten Kondensator (C2) aufweist, der zwischen den Eingang und den Ausgang des Komparators (K) geschaltet ist.

3. Umrichter mit einer Verzögerungsschaltung nach Anspruch 1 oder 2, bei der die Einschaltverzögerung (Ton) größer als die Ausschaltverzögerung (Toff) ist.

4. Umrichter mit einer Verzögerungsschaltung nach einem der Ansprüche 1 bis 3, wobei ein Einschaltpegel des Komparators (K) zwischen dem Low-Pegel (L) und dem High-Pegel (H) liegt, und ein Ausschaltpegel des Komparators (K) zwischen dem Low-Pegel (L) und dem Einschaltpegel liegt.

## Claims

1. Converter having a delay circuit for a PWM signal (A, nA) applied to the input (e) of the delay circuit (D), which delay circuit delays rising edges of the PWM signal (A, nA) by a switch-on delay (Ton) and delays falling edges of the PWM signal (A, nA) by a switch-off delay (Toff) in order to form a drive signal (A', nA') for a semiconductor switching element (TH, TL), which drive signal is applied to the output (a) of the delay circuit (D),

- the input (e) being connected, via a series circuit comprising a first resistor (R1) and a second resistor (R2), to a first connection of a first capacitor (C1) whose second connection is constantly at a low level (L),

- the first connection of the first capacitor (C1) being connected to an input of a comparator (K) whose output forms the output (a) of the delay circuit (D), which output changes between a high level (H) and a low level (L) depending on a voltage level at the input of the comparator (K), the voltage level at the input of the comparator (K) depending on the state of charge of the first capacitor (C1),

- a diode (D1) being connected in parallel with the second resistor (R2) in such a manner that this second resistor (R2), together with the first resistor (R1), limits a charging current for the first capacitor (C1) in the event of a change from a low level (L) to a high level (H) at the input (e) of the delay circuit (D), while the discharging current of the first capacitor is limited only by the first resistor (R1) in the event of a change from a high level (H) to a low level (L) at the input (e).

2. Converter having a delay circuit according to Claim 1, in which the delay circuit (D) also has a second capacitor (C2) which is connected between the input and the output of the comparator (K).

3. Converter having a delay circuit according to Claim 1 or 2, in which the switch-on delay (Ton) is greater than the switch-off delay (Toff).

4. Converter having a delay circuit according to one of Claims 1 to 3, a switch-on level of the comparator (K) being between the low level (L) and the high level (H), and a switch-off level of the comparator (K) being between the low level (L) and the switch-on level.

## Revendications

1. Onduleur comprenant un circuit à retard destiné à un signal MIL (Modulation d'impulsions en largeur) (A, nA) appliqué à une entrée (e) du circuit à retard (D), au moyen duquel les fronts montants du signal MIL (A, nA) sont retardés d'un retard d'activation (Ton) et les fronts descendants du signal MIL (An, nA) sont retardés d'un retard de désactivation (Toff) pour former un signal de commande (A', nA') appliqué à la sortie (a) du circuit à retard (D) et destiné à un élément à semiconducteur (TH, TL), dans lequel

- l'entrée (e) est reliée par l'intermédiaire d'un circuit série d'une première résistance (R1) et d'une seconde résistance (R2) à une première borne d'un premier condensateur (C1) dont la seconde borne est constamment à un niveau bas (L),

- la première borne du premier condensateur (C1) est reliée à une entrée d'un comparateur (K) dont la sortie constitue la sortie (a) du circuit à retard (D), qui bascule en fonction d'un niveau de tension à l'entrée du comparateur (K) entre un niveau haut (H) et un niveau bas (L), dans lequel le niveau de tension à l'entrée du comparateur (K) dépend de l'état de charge du premier condensateur (C1),

- une diode (D1) est connectée en parallèle à la seconde résistance (R2) de manière à ce que cette seconde résistance (R2), en association avec la première résistance (R1), limite un courant de charge destiné au premier condensateur (C1) lors d'un basculement d'un niveau bas (L) à un niveau haut (H) à l'entrée (e) du circuit à retard (D), alors que le courant de décharge du condensateur n'est limité que par la première résistance (R1) lors d'un basculement d'un niveau haut (H) à un niveau bas (L) à l'entrée (e).

2. Onduleur comprenant un circuit à retard selon la revendication 1, dans lequel le circuit à retard (D) comprend en outre un second condensateur (C2) qui est connecté entre l'entrée et la sortie du comparateur (K).

3. Onduleur comprenant un circuit à retard selon la revendication 1 ou 2, dans lequel le retard d'activation (Ton) est supérieur au retard de désactivation (Toff).

4. Onduleur comprenant un circuit à retard selon l'une quelconque des revendications 1 à 3, dans lequel un seuil d'activation du comparateur (K) se situe entre le niveau bas (L) et le niveau haut (H), et dans lequel un niveau de désactivation du comparateur (K) se situe entre le niveau bas (L) et le niveau d'activation.

## FIG. 1

FIG. 2

FIG. 3

FIG. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005020805 A1
- JP 58034620 A